# EUROPEAN PATENT APPLICATION

(11) **EP 4 766 135 A1**
(43) Date of publication of application: **24.06.2026**
(21) Application number: 25223394.5
(22) Date of filing: 15.12.2025
(51) Int. Cl.: H10W 20/40, H10D 1/68, H10D 84/00, H10W 44/20, H10W 44/00, H10W 72/50, H10W 90/00

(54) **A SEMICONDUCTOR DEVICE WITH A CAPACITOR STRUCTURE ADJACENT AN ACTIVE SEMICONDUCTOR REGION**

(30) Priority: 17.12.2024 US 202418983687
(71) Applicant: NXP USA, Inc., Austin, TX 78735 (US)
(72) Inventor: KABIR, Humayun, 5656AG Eindhoven (NL); KHALIL, Ibrahim, 5656AG Eindhoven (NL); WU, Yu-Ting David, 5656AG Eindhoven (NL); GREEN, Bruce McRae, 5656AG Eindhoven (NL); KIM, Taek Kyu, 5656AG Eindhoven (NL)
(74) Representative: Schwarzweller, Thomas

(57) **Abstract**

A semiconductor device configured to reduce the size of passive components monolithically integrated with active components includes a semiconductor substrate that includes an active region, a first current-carrying electrode formed in the active region, a second current-carrying electrode formed in the active region, a control electrode configured to control current flow between the first current-carrying electrode and the second current-carrying electrode. A capacitor structure is formed over the semiconductor substrate adjacent the active region. The capacitor structure includes a first capacitor region that includes a portion of a first conductive layer formed over the semiconductor substrate. A first insulating layer is formed over the first capacitor region. A second capacitor region that includes a portion of a second conductive layer is formed over the first insulating layer. In an embodiment, a contact area is coupled to the capacitor structure.

## Description

### TECHNICAL FIELD

Embodiments of the subject matter described herein relate generally to semiconductor devices.

### BACKGROUND

Semiconductor devices are finding increased use in radio-frequency (RF) applications. Conventional integrated RF semiconductor devices may include integrated passive components. However, these conventional integrated RF semiconductor devices can be difficult to realize in commercial RF applications because the size of integrated passive components is often too large to economically fabricate them on the same substrate as the active components. In practice, this means that passive components must be incorporated off-chip resulting in components that may be excessively large and difficult to integrate into systems with small form factors.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is an isometric view of an exemplary semiconductor device, according to an embodiment;
FIGs 2A, 3A, 4A, and 5A are isometric views of various areas of FIG. 1;
FIGs 2B, 2C, 3B, 4B, and 5B, are corresponding cross-sectional views of the semiconductor device 100 of FIGs 2A, 3A, 4A, and 5A along cut lines 2B, 2C, 3B, 4B, and 5B;
FIG. 6 is an isometric view of a semiconductor device in accordance with an embodiment;
FIG. 7 is an isometric view of a packaged semiconductor device with external components; and
FIG. 8 is an isometric view of a packaged semiconductor device in accordance with an embodiment;
FIG. 9A is an isometric view of an area of the packaged semiconductor device of FIG. 8, according to an embodiment; and
FIGs 9B and 9C are corresponding cross-sectional views of the packaged semiconductor device FIG. 8 as seen in the view of FIG. 9A along cut lines 9B and 9C, according to an embodiment.

### SUMMARY OF THE INVENTION

In one aspect, a semiconductor device may include a semiconductor substrate that includes an active region, a first current-carrying electrode formed in the active region, a second current-carrying electrode formed in the active region, a control electrode configured to control current flow between the first current-carrying electrode and the second current-carrying electrode. The control electrode may be formed between the first current-carrying electrode and the second current-carrying electrode, according to an embodiment. In an embodiment, a capacitor structure may be formed over the semiconductor substrate adjacent the active region. The capacitor structure may include a first capacitor region that includes a portion of a first conductive layer formed over the semiconductor substrate, according to an embodiment. An embodiment may include a first insulating layer formed over the first capacitor region. A second capacitor region that includes a portion of a second conductive layer may be formed over the first insulating layer, according to an embodiment. In an embodiment, a contact area may be coupled to the capacitor structure.

According to an embodiment, a bond wire may be coupled to the contact area. The contact area may be formed on a bond pad that includes at least one selected from the group consisting of the first conductive layer and the second conductive layer, according to an embodiment.

An embodiment may include a keep-out region may include a portion of the bond pad, wherein the contact area may be outside the keep-out region.

In an embodiment, the keep-out region may include the capacitor structure.

The keep-out region further may include a component that includes inductors, resistors, and diodes, according to an embodiment.

In an embodiment, the contact area may be formed within an opening formed in the first insulating layer. The opening may be formed over the first conductive layer and laterally adjacent the capacitor structure.

The contact area may be formed in an opening in a second insulating layer, over the second conductive layer, and over the capacitor structure, according to an embodiment.

In an embodiment, an inductor structure may be formed adjacent the capacitor structure, wherein the inductor structure may be electrically coupled to the capacitor structure.

The inductor structure may include a spiral structure formed from the second conductive layer over the semiconductor substrate, wherein the inductor may include a first exterior inductor electrode coupled to an exterior portion of the spiral structure, and an underpass structure that includes the first conductive layer between the spiral structure and the semiconductor substrate that electrically couples an interior portion of the spiral structure to a second exterior inductor electrode, according to an embodiment.

In an embodiment, the inductor structure may include a spiral structure formed from the first conductive layer over the semiconductor substrate, wherein the inductor structure includes a first exterior inductor electrode coupled to an exterior portion of the spiral structure, and an overpass structure that includes the first conductive layer over the spiral structure that electrically couples an interior portion of the spiral structure to a second exterior inductor electrode.

The capacitor structure and the inductor structure may be formed under the contact area, according to an embodiment.

The first current-carrying electrode may be configured as a source electrode, the second current-carrying electrode may be configured as a drain electrode, and the control electrode may be configured as a gate electrode, according to an embodiment.

In an embodiment a bond pad may be formed from one or more of the first conductive layer and the second conductive layer and may be electrically coupled to one of the gate electrode, the drain electrode, and the source electrode.

In an embodiment, the contact area may be formed outside a keep-out region, wherein the keep-out region includes the capacitor structure.

In an embodiment, a bond wire may be coupled to the contact area.

In an embodiment, the capacitor structure and the bond wire structure may be electrically coupled and are configured to terminate one of the impedance of the gate electrode and the drain electrode at one of a fundamental frequency and a harmonic frequency of a frequency of operation of the semiconductor device.

In an embodiment, the first capacitor region may be electrically coupled to a through wafer via formed in the semiconductor substrate, wherein the capacitor structure is arranged in a shunt capacitor configuration.

In another aspect, the inventive subject matter may include an apparatus that includes a semiconductor die that includes a transistor active area, wherein the transistor active area may include a source electrode, a drain electrode, a gate electrode formed between the source electrode and the drain electrode, wherein the gate electrode is configured to control a current between the source electrode and the drain electrode, according to an embodiment. In an embodiment, a gate bond pad may be electrically coupled to the gate electrode and a drain bond pad may be electrically coupled to the drain electrode. A metal-insulator-metal (MIM) capacitor structure may be integrally formed within at least one of the gate bond pad and the drain bond pad, adjacent the transistor active area, and electrically coupled to the transistor active area, according to an embodiment. The MIM capacitor structure may include a bottom plate formed over the semiconductor substrate, an insulating layer formed over the bottom plate, a top plate formed over the insulating layer, and a contact area electrically coupled to the capacitor structure according to an embodiment.

In an embodiment, the apparatus may further comprise a package that includes a flange, lead frame coupled to the flange, a gate lead coupled to the lead frame, and a drain lead coupled to the lead frame. The semiconductor die may be coupled to the flange, the gate lead may be electrically coupled to the gate electrode, and the drain lead may be electrically coupled to the drain electrode.

In an embodiment of the apparatus, a bond wire may be coupled to the contact area.

In an embodiment of the apparatus, the capacitor structure and the bond wire may be electrically coupled and may be configured to terminate an impedance of one of the gate electrode and the drain electrode at a frequency of one of a fundamental frequency and a harmonic frequency of operation of the apparatus.

### DETAILED DESCRIPTION

Various embodiments of the inventive subject matter, pertaining to semiconductor devices described herein, include a semiconductor device with capacitors integrated into bond pads formed adjacent an active semiconductor region. The semiconductor device embodiments provided herein may overcome some or all of the aforementioned issues with integrated RF devices, while realizing these semiconductor devices in a compact form factor.

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or the following detailed description.

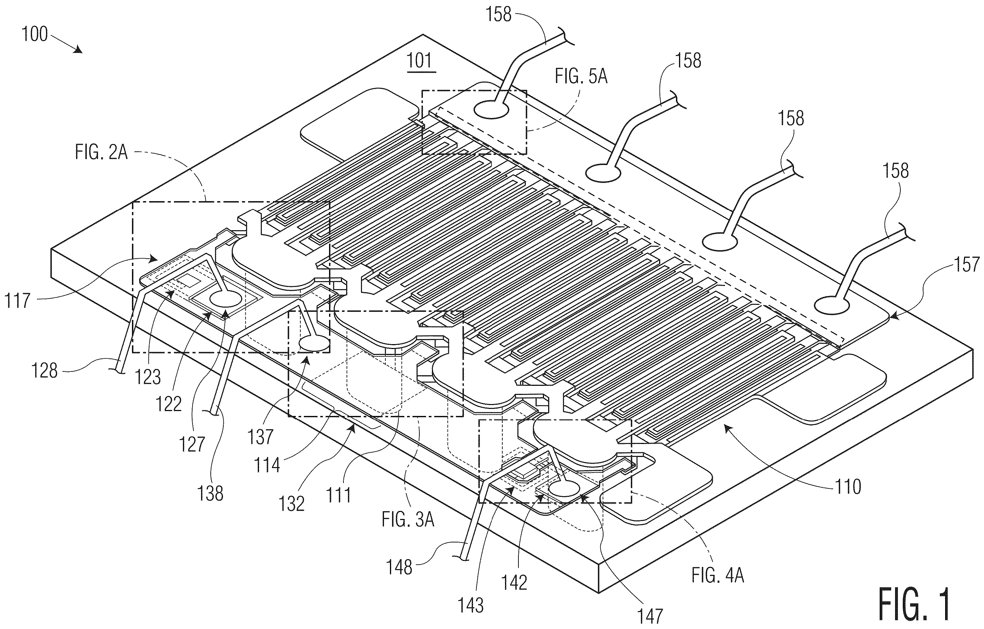

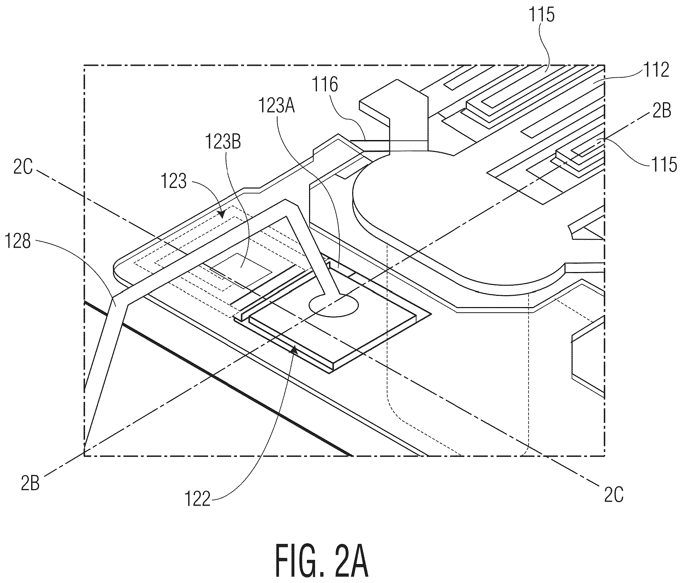

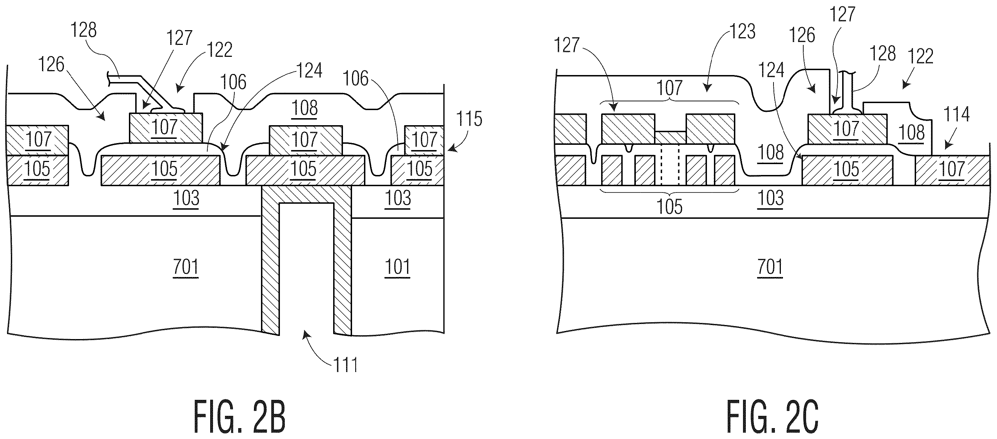

FIG. 1 is an isometric view of an exemplary semiconductor device 100, according to an embodiment. FIGs 2A, 3A, 4A, and 5A are isometric views of various areas. FIGs 2B, 2C, 3B, 4B, and 5B, are corresponding cross-sectional views of the semiconductor device 100 of FIGs 2A, 3A, 4A, and 5A along cut lines 2B, 2C, 3B, 4B, and 5B in accordance with an embodiment. FIG. 1 may be best understood while simultaneously viewing FIGs 2A, 2B, 2C 3A, 3B, 4A, 4B, 5A, and 5B.

Semiconductor device 100 may include a semiconductor device includes a semiconductor substrate 101, an active transistor region 110 (i.e., "active region"), a first current-carrying electrode 112 formed in the active transistor region 110, a second current-carrying electrode 115 formed in the active transistor region 110, a control electrode 116 configured to control current flow between the second current-carrying electrode 115 and the first current-carrying electrode 112. The control electrode 116 may be formed between the first current-carrying electrode 112 and the second current-carrying electrode 115, according to an embodiment.

Semiconductor substrate 101 may include one or more of silicon, gallium nitride (GaN), gallium arsenide (GaAs), indium phosphide (InP), or other suitable material(s). In an embodiment, the transistor active region 110 has an output capacitance between the first and second current-carrying terminals. In an embodiment, active transistor region 110 may include field effect transistors (FET's) (such as heterojunction FET's (HFET's), metal-semiconductor FET's (MESFET's), or metal oxide semiconductor FET's (MOSFET's)), each of which include a gate electrode (control electrode), a source electrode (a first current-carrying electrode), and a drain electrode (a second current-carrying electrode). For convenience of explanation and not for limitation, various embodiments of the invention will be illustrated using GaN HFET active devices, which are preferred. However, many other active device types may also be employed and are intended to be included within the scope of the invention, as for example and not intended to be limiting, bipolar devices, junction field effect devices, various insulated gate field effect devices, and so forth. Alternatively, the active transistor region 110 may include a bipolar junction transistor (BJT) or a heterojunction BJT (HBT). Accordingly, references herein to a "gate," "drain," and "source" are not intended to be limiting, as each of these designations has analogous features for a bipolar device implementation (e.g., a base, collector, and emitter, respectively).

Gate bond pad 117 may be electrically coupled to the gate electrode 116 and drain bond pad 157 may be electrically coupled to drain electrode 115, according to an embodiment. Gate and drain bond pads 117 and 157 may be formed from first metal layer 105 (i.e., "first conductive layer") and/or second metal layer 107 (i.e., "second conductive layer").

In an embodiment, one or more capacitor structures 122, 132, 142, 152 may be formed over the semiconductor substrate 101 adjacent the active region 110. The capacitor structures 122, 132, 142, 152 may include bottom plates 124, 134, 144, 154 (i.e., "first capacitor regions") that include a portion of first metal layer 105 formed over the semiconductor substrate 101 and dielectric layer 103 (e.g. SiN, SiO2), according to an embodiment. An embodiment may include a first insulating layer 106 (e.g. silicon nitride (SiN), silicon oxide (SiO2), or other suitable insulating layer) formed over the bottom plates 124, 134, 144, 154. First insulating layer may between about 100 angstroms and about 10,000 angstroms in thickness, though other thicknesses may be used. Top plates 126, 136, 146, 156 (i.e., "second capacitor regions") that includes a portion of a second metal layer 107 (i.e., "second conductive layer") may be formed over the first insulating layer 106, according to an embodiment.

In an embodiment, contact areas 127, 137, 147, 159 may be coupled to the capacitor structures 122, 132, 142, 152. Contact areas may be formed in an opening in a second insulating layer 108, over the second conductive layer 107 and/or first conductive layer 105, according to an embodiment.

According to an embodiment, bond wires 128, 138, 148, 158 may be coupled or attached to contact areas 127, 137, 147, 159. Contact areas 127, 137, 147, 159 may be integrally formed on or as part of gate bond pad 117 and contact area 159 may be integrally formed as part of drain bond pad 157, both of which may be formed from first metal layer 105 and/or a second metal layer 107, according to an embodiment. In an embodiment, contact areas 127, 137, 147, 159 may be electrically coupled to bottom plates 124, 134, 144, 154 and/or top plates 126, 136, 146, 156 of capacitor structures 122, 132, 142, 152.

Keep-out region 114 may be optionally formed and may include a portion of the gate bond pad 117 and or drain bond pad 157 (not shown), according to an embodiment. As used herein, the term "keep out region" means regions of gate bond pad 117 that excludes contact areas 137 and that bond wire 138 is not bonded to it. While in this illustrative example, keep out region 114 is implemented in connection with capacitor region 132, in other embodiments, other keep-out regions may include capacitor structures 122, 132, 142, 152 without limitation. In an embodiment, contact area 137 may be outside the keep-out region 114. Keep out region 114 is formed to protect components, e.g. capacitor structures 132 from damage caused by forming bond wire contact to bond pad 117. Keep-out region 114 may include regions of gate bond pad 117 that include first metal layer 105 and/or second metal layer 107, according to an embodiment. Keep-out region 114 may further include other components that may include inductors, resistors, and diodes.

In an embodiment, inductor structures 123, 143 may be formed adjacent the capacitor 122 structure, wherein the inductor structures 123, 143 may be electrically coupled to the capacitor structures 122, 142. The inductor structures 123, 143 may include a spiral structure formed from at least one of the first or second metal layers 105, 107 over the semiconductor substrate 101, wherein the inductor structures 123, 143 may include a first exterior inductor electrode 123A coupled to an exterior portion of the spiral structure, and an interior connection structure that electrically couples an interior portion of the spiral structure to a second exterior inductor electrode 123B, according to an embodiment.

In an embodiment, the capacitance of the capacitor structures 122, 132, 142, 152 may be between about 0.1 picofarads (pF) and about 100 pF, although higher or lower values may be used. Likewise, the inductance of inductor structure 123, 143 may be between about 0.01 nanohenries and about 10 nanohenries (nH) although other higher or lower values may be used, according to an embodiment.

In an embodiment, the view of FIGs 2A, 2B, and 2C illustrates the creation of an L-C-L connection to the gate bond pad 117 and gate electrode 116. This is accomplished through the series connection of bond wire 128 with its inherent inductance to couple bond wire 128 to top plate 126 in contact area that is electrically coupled to bottom plate 124 that is in turn electrically coupled to the exterior connection 123A of inductor structure 123 whose exterior terminal 123B is electrically coupled to gate bond pad 117 that is in turn electrically coupled to gate electrode 116, according to an embodiment.

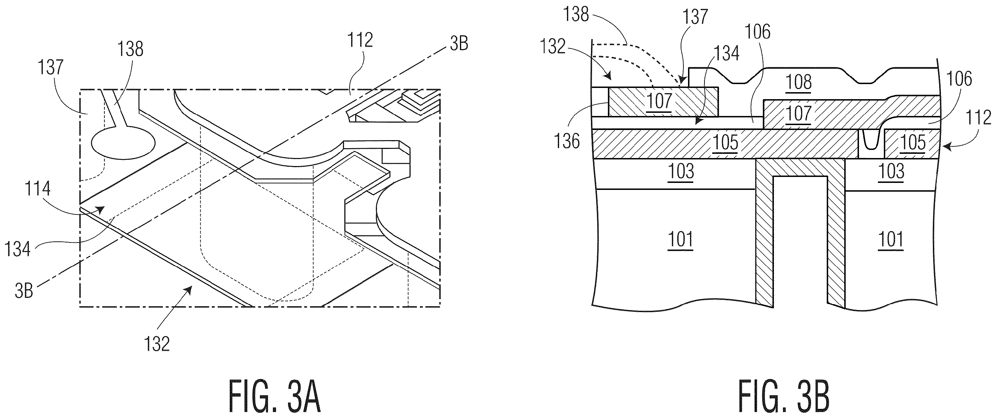

In an embodiment, the view of FIGs 3A and 3B illustrates the creation of an L-C, shunt-C connection to the gate bond pad 117 and gate electrode 116. This is accomplished through the series connection of bond wire 138 to couple bond wire 138 to top plate 136 in contact area 137 that is electrically coupled to bottom plate 134 that is coupled to source electrode 112 by way of through-wafer via 111, according to an embodiment.

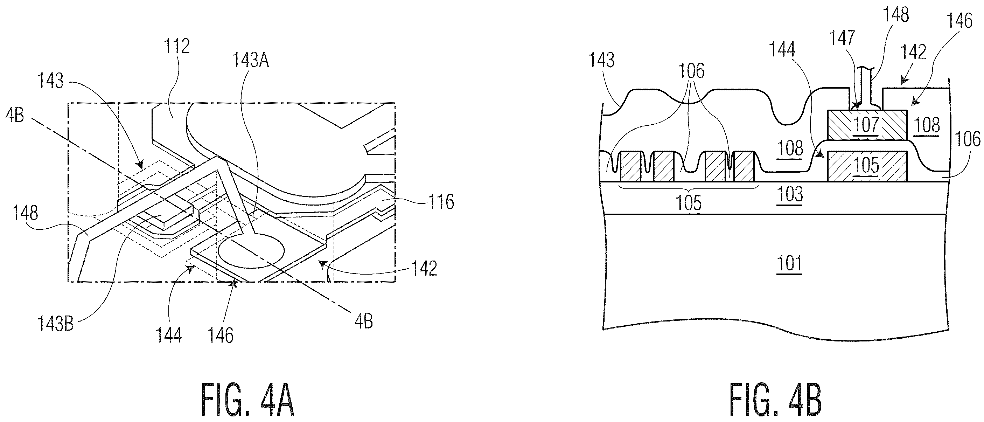

In an embodiment, the view of FIGs 4A and 4B illustrates the creation of a shunt L-C connection of the gate bond pad 117 to source electrode 112. This is accomplished through the coupling of top plate 146 to gate electrode 116, according to an embodiment. Bottom plate 144 is coupled to inductor structure 143 which is in turn coupled to source electrode 112 and through-wafer via 111, according to an embodiment.

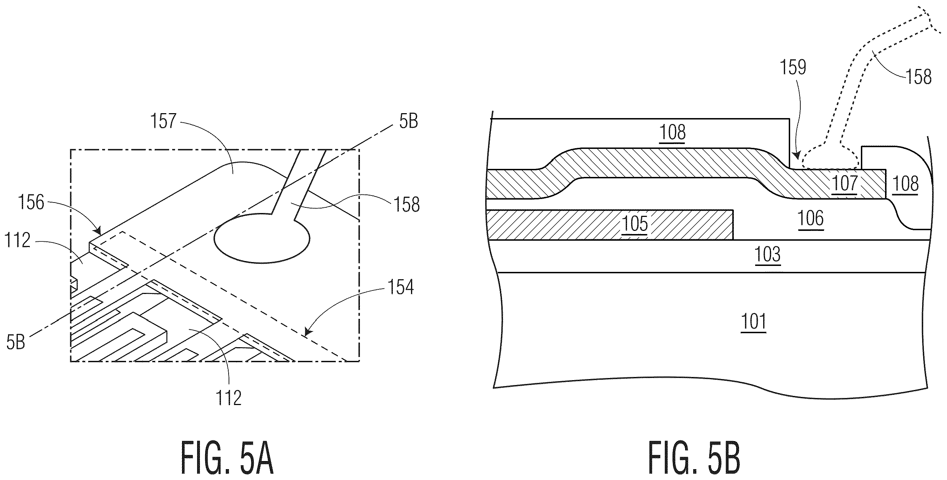

In an embodiment, the view of FIGs 5A and 5B illustrates the creation of a shunt C connection of the drain bond pad 157 to source electrode 112. This is accomplished through the coupling of top plate 156 to drain electrode 115, according to an embodiment. Bottom plate 154 is coupled to source electrode 112, according to an embodiment.

It should be appreciated that semiconductor device 100 is for illustration purposes and is configured to show various aspects of the inventive subject matter. For example, other configurations of circuit elements created from capacitor structures 122, 132, 142, 152 and inductor structures 123, 143 may be used in other configurations without limitation. Moreover, in other embodiments, semiconductor devices may be configured to include only some of the components of semiconductor device 100 and additional components such as other transistors, diodes, resistors, and other components without limitation.

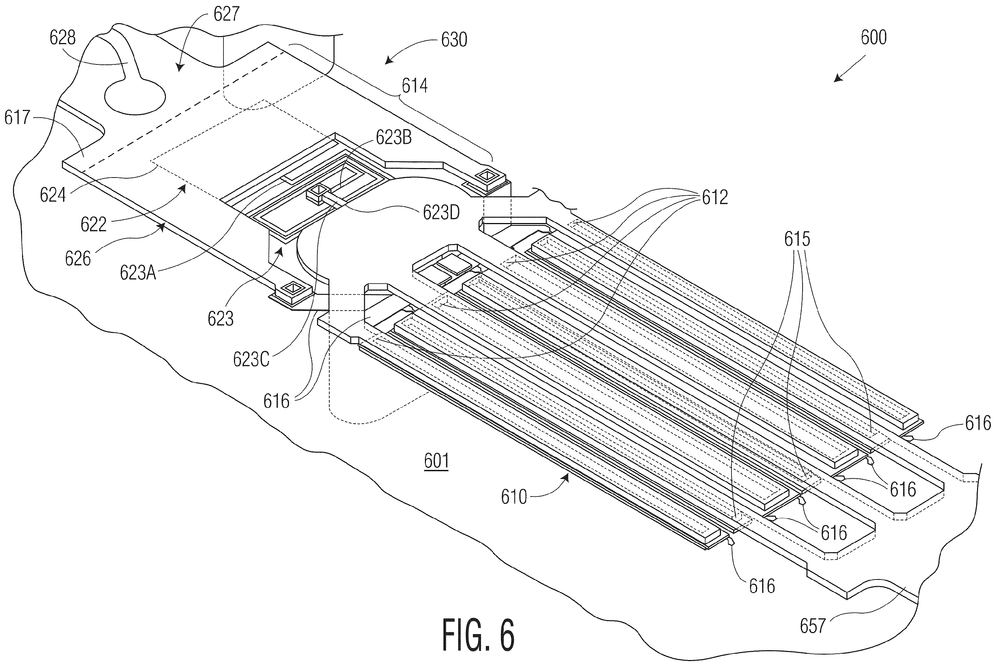

FIG. 6 is an isometric view of semiconductor device 600 in accordance with another example embodiment that includes harmonic termination circuit 630. Semiconductor device 600 may include a semiconductor substrate 601, an active transistor region 610, source electrode 612 formed in the active transistor region 610, a drain electrode 615 formed in the active transistor region 610, a gate electrode 616 configured to control current flow between the drain electrode 615 and the source electrode 612. The gate electrode 616 may be formed between the source electrode 612 and the drain electrode 615, according to an embodiment.

A gate bond pad 617 may be electrically coupled to the gate electrode 616 and drain bond pad 657 may be coupled to drain electrode 615, according to an embodiment. Gate and drain bond pads 617, 657 may be formed from a first metal layer (i.e., "first conductive layer") and/or second metal layer 607/ In an embodiment, capacitor structure 622 may be formed over the semiconductor substrate 601 adjacent the active transistor region 610. The capacitor structure 622 includes bottom plate 624 that include a portion of a first metal layer that may be used to form gate electrode 616, according to an embodiment. Also as illustrated in connection with the semiconductor device 600 and bottom plates 124, 134, 144 of FIG. 1, an embodiment may include a first insulating layer formed over the bottom plate 624 (not shown). Top plates 626 that includes a portion of a second metal layer may be formed over the first insulating layer (not shown), according to an embodiment. In an embodiment, contact area 627 may be coupled to the capacitor structures 622.

According to an embodiment, bond wire 628 may be coupled or attached to contact areas 627. Contact areas 627 may be integrally formed on or as part of bond pad 617 that is formed from the first metal layer, according to an embodiment. In an embodiment, contact area 627 may be electrically coupled to top plate 626 of capacitor structures 622.

In an embodiment, inductor structure 623 may be formed adjacent the capacitor 622 structure. The inductor structure 623 may be electrically coupled to the capacitor structures 622, according to an embodiment. The inductor structures 623 may include a spiral structure formed from at least one of the first or second metal layers over the semiconductor substrate 601, wherein the inductor structure 623 may include a first exterior inductor terminal 623A coupled to an exterior terminal of the spiral structure, and an overpass structure 623C that includes the second metal layer formed over the inductor structure 623 that electrically couples an interior portion of the inductor structure to a second exterior inductor electrode 623B, according to an embodiment.

In an embodiment, a harmonic termination circuit 630 may be created using a connection of the capacitor structure 622 and inductor structure 623. Harmonic termination circuit 630 may be formed within keep-out region 614. In an embodiment, bond wire 628 may be coupled to contact area 627 integrally formed in gate bond pad 617. The top plate 626 of capacitor structure 622 may be integrally formed in gate bond pad 617 and or otherwise coupled to gate bond pad 617 and may be electrically coupled to gate electrode 616, according to an embodiment. The bottom plate 624 of capacitor structure 622 may be electrically coupled in series to one of the first or second exterior terminals 623A, 623B of inductor structure 623. The one of the first or second exterior terminals 623A, 623B not directly connected to the bottom plate 624 may be electrically coupled to the source electrode 612 to form a shunt L-C network that electrically couples gate electrode 616 to a ground potential coupled to the source electrode 612. The harmonic termination circuit 630 may be configured to terminate the impedance seen by the gate electrode 616 at a harmonic frequency of a frequency of operation of the semiconductor device 600 to increase the drain efficiency of a power amplifier created using semiconductor device 600, according to an embodiment. In an embodiment, the capacitance of the capacitor structure 622 may between about 0.1 pF and about 100 pF, although higher or lower values may be used. Likewise, the inductance of inductor structure 623 may be between about 0.01 nH and about 10 nH although other higher or lower values may be used, according to an embodiment.

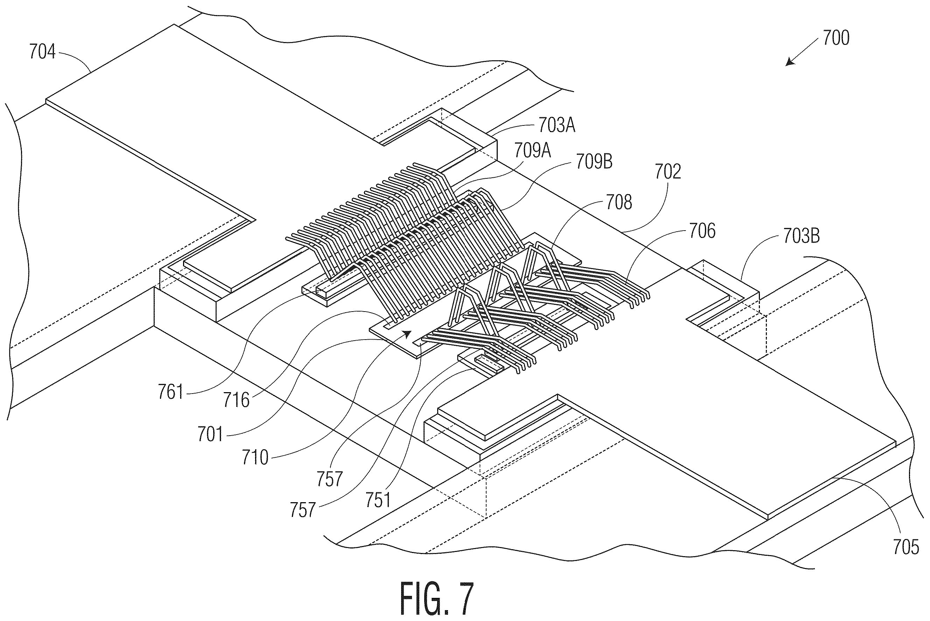

FIG. 7 is an isometric view of an example of a packaged semiconductor device 700 with external components. Packaged semiconductor device 700 includes a semiconductor die 701. Semiconductor die 701 includes transistor region 710. Semiconductor die 701 is mounted to package flange 702. Lead frame 703A, 703B is bonded to package flange 702. Gate lead 704 and drain lead 705 are bonded to lead frames 703A, 703B. Drain bond pad 757 of semiconductor die 701 is electrically connected to drain lead 705 via bond wires 706. Output matching die 751 is bonded to package flange 702 between drain lead 705 and semiconductor die 701 via bond wires 708. Gate bond pad 716 is electrically connected to input matching circuit die 761 with bond wires 709A input matching circuit die 761 is electrically connected to gate lead 704 with bond wires 709B.

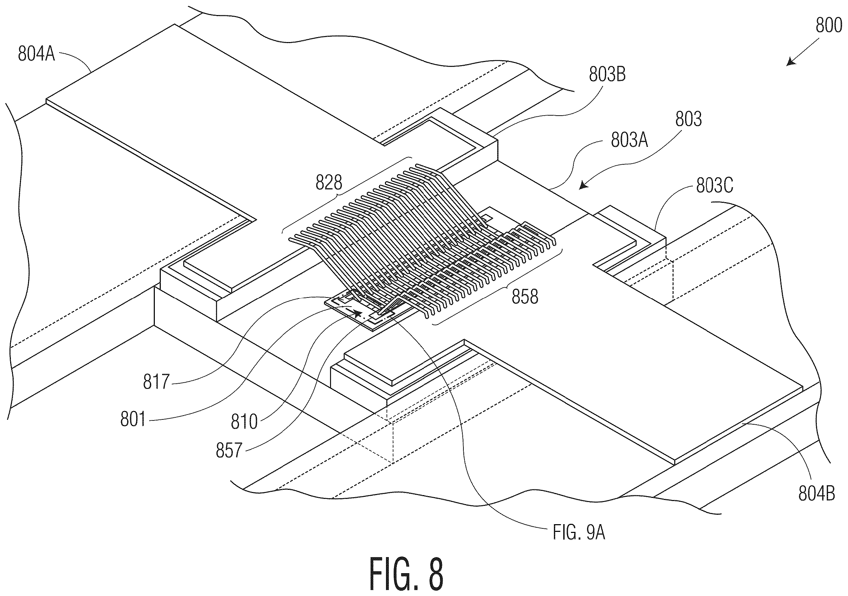

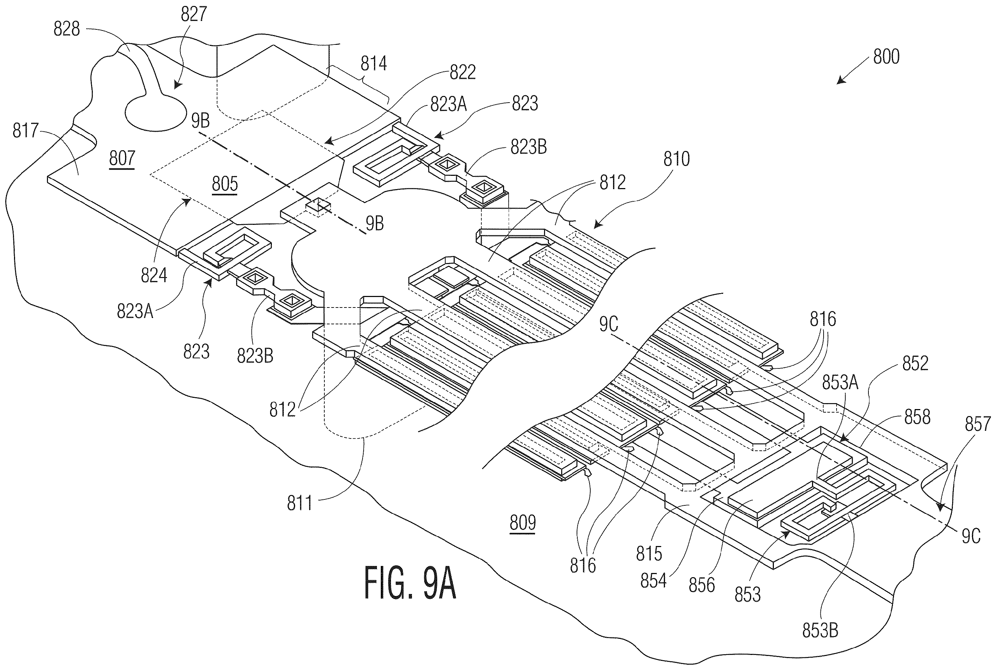

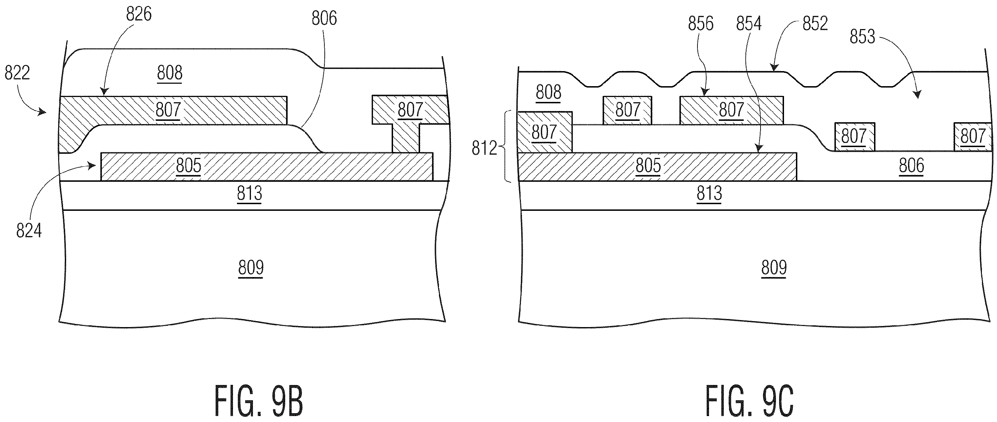

FIG. 8 is an isometric view of a packaged semiconductor device 800 (i.e., "apparatus") in accordance with an embodiment. FIG. 9A is an isometric view of an area of FIG. 8. FIGs 9B and 9C are corresponding cross-sectional views of the packaged semiconductor device of FIG. 8 as seen in the view of FIG. 9A along cut lines 9B and 9C. FIG. 8 may be best understood by simultaneously viewing FIGs 8, 9A, 9B, and 9C.

The packaged semiconductor device 800 includes the functionality of packaged semiconductor device 700 with external components of FIG. 7 with pre-matching of the input and output of the device, but may be realized with less assembly complexity and reduced size because the functional equivalents of the input matching die 761 and output matching die 751 and bond wires that connect input/output matching die to semiconductor die 701 may be integrated into semiconductor die 801 used to form packaged semiconductor device 800.

In an embodiment, packaged semiconductor 800 device may include a semiconductor die 801 coupled to package 803 that includes flange 803A, lead frame 803B/803C coupled to flange 803A, a gate lead 804A coupled to the lead frame 803B, and a drain lead 804B coupled to lead frame 803C. The semiconductor die 801 may include transistor active area 810 and may be coupled to the flange 803A. The gate lead 804 may be electrically coupled to the gate electrode 816, and the drain lead 804B may be electrically coupled to the drain electrode 815. Gate bond wires 828 may electrically couple gate bond pad 817 to gate lead 804A and drain bond wires 858 may electrically couple drain bond pad 857 to drain lead 804B, according to an embodiment.

Transistor active area 810 may be formed within semiconductor die 801. Semiconductor die 801 includes semiconductor substrate 809. Transistor active area 810 may be formed within semiconductor substrate 809 and may include source electrodes 812, drain electrodes 815, and gate electrodes 816 formed between the source electrode 812 and the drain electrode 815, according to an embodiment. Through wafer vias 811 may electrically couple source electrode 812 to backside metal on the bottom of the semiconductor substrate 809 for low inductance connections (not shown).

In an embodiment, a gate bond pad 817 may be electrically coupled to the gate electrodes 812 and a drain bond pad 857 may be electrically coupled to the drain electrodes 815. Metal-insulator-metal (MIM) capacitor structures 822, 852 may be integrally formed within gate bond pad 817 and the drain bond pad 857, adjacent the transistor active area 810, and electrically coupled to the transistor active area 810, according to an embodiment. MIM capacitor structures may be formed over dielectric layer 813, according to an embodiment. Inductor structures 823, 853 may be electrically coupled to MIM capacitor structures 822, 852, according to an embodiment.

The MIM capacitor structures 822, 852 may include bottom plates 824, 854 formed over the semiconductor substrate 809, a first insulating layer 806 formed over the bottom plates 824, 854, top plates 824, 826 formed over the insulating layer, and contact area 827 electrically coupled to the MIM capacitor structures 822, 852, according to an embodiment. The contact area 827 may be formed as an opening in second insulating layer 808 (not shown). The MIM capacitor structure 822 may be formed in keep-out region 814, according to an embodiment.

Inductor structures 823, 853 may be electrically coupled to MIM capacitor structures 822, 852, according to an embodiment. The inductor structures 823, 853 may include a spiral structure formed from at least one of the first or second metal layers 805, 807 formed over the semiconductor substrate 809, and dielectric layer 813 wherein the inductor structures 823, 853 may include first exterior inductor terminals 823A, 853A coupled to the spiral structure of inductor structures 823, 853 and underpass structures 823C, 853C that includes the first metal layer 805 formed over the inductor structure 823 that electrically couples interior portions of inductor structures 823, 853 to second exterior inductor electrodes 823B, 853B, according to an embodiment.

In an embodiment, top plate 826 of capacitor structure 822 electrically couples gate pad 817 to bottom plate 824. Bottom plate 824 is electrically coupled to source and package ground through through-wafer via 811. This arrangement may be configured to provide the same functional equivalence of the shunt L-C matching network connection of bond wires 709A to the shunt capacitance of input matching die 761 of the packaged semiconductor device 700 of FIG. 7, according to an embodiment. Also, the series connection of top plate 826 of capacitor structure 822 to inductor structures 823 and connection of inductor structures 823 to gate electrode 816 may provide a series inductance equivalent to the series inductance imparted by bond wires 709B connection between input matching die 761 and gate bond pad 716 of the packaged semiconductor device 700 of FIG. 7. Likewise, in an embodiment, the series connection of top plate 856 of MIM capacitor structure 852 to drain pad 857 with inductor structure 853 electrically couples drain pad 857 to source electrode 812 and package ground through wafer via 812A with a shunt L-C connection. This arrangement may be configured to provide the same functional equivalence of the shunt L-C matching network connection of bond wires 708 from drain bond pad 757 to the shunt capacitance of output matching die 751 of the packaged semiconductor device 700 of FIG. 7, according to an embodiment.

In an embodiment, the capacitance of the MIM capacitor structures 822, 852 may between about 0.1 pF and about 100 pF, although higher or lower values may be used. Likewise, the inductance of inductor structures 823, 853 may be between about 0.01 nH and about 10 nH although other higher or lower values may be used, according to an embodiment. In one example, inductor structure 823 with an inductance of between about 0.110 nH and about 0.130 nH, and capacitor structure 822 with a value between about 26 pF and about 28 pF may be used to achieve an impedance match for gate electrode 816 at a fundamental frequency of about 2.7 gigahertz.

In examples, of the semiconductor device as disclosed, the capacitor structure and the bond wire are electrically coupled and are configured to terminate an impedance of one of the group consisting of the gate electrode and the drain electrode at a frequency of one selected from the group consisting of a fundamental frequency and a harmonic frequency of operation of the semiconductor device. In examples, the first capacitor region is electrically coupled to a through wafer via formed in the semiconductor substrate, wherein the capacitor structure is arranged in a shunt capacitor configuration.

The present disclosure extends to an apparatus comprising: a semiconductor die that includes a transistor active area, wherein the transistor active area includes a source electrode, a drain electrode, a gate electrode between the source electrode and the drain electrode, wherein the gate electrode is configured to control a current between the source electrode and the drain electrode; a gate bond pad electrically coupled to the gate electrode;

a drain bond pad electrically coupled to the drain electrode; a metal-insulator-metal (MIM) capacitor structure integrally formed within at least one selected from the group consisting of the gate bond pad and the drain bond pad, adjacent the transistor active area, and electrically coupled to the transistor active area, wherein the MIM capacitor structure comprises: a bottom plate formed within the semiconductor die; an insulating layer formed over the bottom plate; a top plate formed over the insulating layer; and a contact area electrically coupled to the capacitor structure.

The apparatus may further comprise: a package that comprises: a flange; a lead frame coupled to the flange; a gate lead coupled to the lead frame; a drain lead coupled to the lead frame; wherein: the semiconductor die is coupled to the flange; the gate lead is electrically coupled to the gate electrode; and the drain lead is electrically coupled to the drain electrode.

In examples, a bond wire is coupled to the contact area.

In examples, the capacitor structure and the bond wire are electrically coupled and are configured to terminate an impedance of one of the group consisting of the gate electrode and the drain electrode at a frequency of one selected from the group consisting of a fundamental frequency and a harmonic frequency of operation of the apparatus.

For the sake of brevity, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.
While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A semiconductor device comprising:
a semiconductor substrate that includes an active region;
a first current-carrying electrode formed in the active region;
a second current-carrying electrode formed in the active region;
a control electrode configured to control current flow between the first current-carrying electrode and the second current-carrying electrode, wherein the control electrode is formed between the first current-carrying electrode and the second current-carrying electrode;
a capacitor structure formed over the semiconductor substrate adjacent the active region,
wherein the capacitor structure comprises:
a first capacitor region that includes a portion of a first conductive layer formed over the semiconductor substrate;
a first insulating layer formed over the first capacitor region;
a second capacitor region that includes a portion of a second conductive layer formed over the first insulating layer; and
a contact area coupled to the capacitor structure.

2. The semiconductor device of claim 1 further comprising a bond wire coupled to the contact area, wherein the contact area is formed on a bond pad that includes at least one selected from the group consisting of the first conductive layer and the second conductive layer.

3. The semiconductor device of claim 2 further comprising a keep-out region comprising a portion of the bond pad, wherein the contact area is outside the keep-out region.

4. The semiconductor device of claim 3, wherein the keep-out region comprises the capacitor structure.

5. The semiconductor device of claim 4, wherein the keep-out region further comprises a component selected from the group consisting of inductors, resistors, and diodes.

6. The semiconductor device of any preceding claim, wherein the contact area is formed within an opening formed in the first insulating layer, wherein the opening is formed over the first conductive layer and laterally adjacent the capacitor structure.

7. The semiconductor device of any preceding claim, wherein the contact area is formed over the second conductive layer, and over the capacitor structure.

8. The semiconductor device of any preceding claim, wherein an inductor structure is formed adjacent the capacitor structure, wherein the inductor structure is electrically coupled to the capacitor structure.

9. The semiconductor device of claim 8, wherein the inductor structure comprises a spiral structure formed from the second conductive layer over the semiconductor substrate, wherein the inductor structure includes a first exterior inductor electrode coupled to an exterior portion of the spiral structure, and an underpass structure that includes the first conductive layer between the spiral structure and the semiconductor substrate that electrically couples an interior portion of the spiral structure to a second exterior inductor electrode.

10. The semiconductor device of claim 8 or 9, wherein the inductor structure comprises a spiral structure formed from the first conductive layer over the semiconductor substrate, wherein the inductor structure includes a first exterior inductor electrode coupled to an exterior portion of the spiral structure, and an overpass structure that includes the first conductive layer over the spiral structure that electrically couples an interior portion of the spiral structure to a second exterior inductor electrode.

11. The semiconductor device of any of claims 8 to 10, wherein the capacitor structure and the inductor structure are formed under the contact area.

12. The semiconductor device of any preceding claim, wherein the first current-carrying electrode is configured as a source electrode, the second current-carrying electrode is configured as a drain electrode, and the control electrode is configured as a gate electrode.

13. The semiconductor device of claim 12, further comprising a bond pad formed from at least one of the group consisting of the first conductive layer and the second conductive layer and is electrically coupled to one of the group consisting of the gate electrode, the drain electrode, and the source electrode.

14. The semiconductor device of claim 13, wherein the contact area is formed outside a keep-out region, wherein the keep-out region includes the capacitor structure.

15. The semiconductor device of claim 14, wherein a bond wire is coupled to the contact area.
